# EUROPEAN PATENT APPLICATION

(11) **EP 4 318 371 A1**
(43) Date of publication of application: **07.02.2024**
(21) Application number: 22856169.2
(22) Date of filing: 09.08.2022
(51) Int. Cl.: G06Q 50/30, G01R 31/367, G01R 31/396, B60L 53/80

(54) **BATTERY OPERATION MANAGEMENT SYSTEM AND OPERATION METHOD OF SAME**

(30) Priority: 13.08.2021 KR 20210107039
(71) Applicant: LG Energy Solution, Ltd., Seoul 07335 (KR)
(72) Inventor: CHOI, Yean Sik, Daejeon 34122 (KR)
(74) Representative: Goddar, Heinz J.
(86) International application number: PCT/KR2022/011839
(87) International publication number: WO 2023/018172

(57) **Abstract**

A battery operation management system includes a data obtaining unit configured to obtain, from a battery pack, operation data of a load, related to a type of the load and state information of the battery pack and a processor configured to evaluate a usage class of a user operating the load based on the operation data of the load and the state information of the battery pack and select a battery pack to be provided to the user based on the usage class of the user in response to a battery pack providing request of the user.

## Description

### [TECHNICAL FIELD]

### CROSS-REFERENCE TO RELATED APPLICATION

This application claims priority to and the benefit of Korean Patent Application No. 10-2021-0107039 filed in the Korean Intellectual Property Office on August 13, 2021, the entire contents of which are incorporated herein by reference.

### TECHNICAL FIELD

Embodiments disclosed herein relate to a battery operation management system and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To further increase the usability and portability of the lithium-ion battery, a battery exchange service has been provided. However, general battery exchange services simply exchange a discharged battery with a fully charged battery, resulting in a limit in terms of service utility and battery management provided for the service.

### [DISCLOSURE]

### [TECHNICAL PROBLEM]

Embodiments disclosed herein aim to provide a battery operation management system and an operating method thereof in which a battery exchange service may be provided considering a battery usage class of a user.

In addition, embodiments disclosed herein aim to provide a battery operation management system and an operating method thereof in which a lifespan of a battery may be managed stably.

Technical problems of the embodiments disclosed herein are not limited to the above-described technical problems, and other unmentioned technical problems would be clearly understood by one of ordinary skill in the art from the following description.

### [TECHNICAL SOLUTION]

A battery operation management system includes a data obtaining unit configured to obtain, from a battery pack, operation data of a load, related to a type of the load and state information of the battery pack and a processor configured to evaluate a usage class of a user operating the load based on the operation data of the load and the state information of the battery pack and select a battery pack to be provided to the user based on the usage class of the user in response to a battery pack providing request of the user.

In an embodiment, the processor may be further configured to select, as the battery pack to be provided to the user, a battery pack having a lower degradation degree for a higher usage class of the user.

In an embodiment, the processor may be further configured to calculate a fuel efficiency of the load based on the operation data of the load and the state information of the battery pack and evaluate the usage class of the user based on the calculated fuel efficiency.

In an embodiment, the type of the load may include a first moving object that travels on the ground and a second moving object that flies.

In an embodiment, the operation data of the first moving object may include traveling distance, a location, and an altitude of the first moving object, and the operation data of the second moving object may include traveling distance, a location, a wind speed, and a wind direction of the second moving object.

In an embodiment, the processor may be further configured to evaluate the usage class of the user by comparing a moving path of the first moving object obtained based on the location of the first moving object with an optimal path considering the altitude, when the load is the first moving object, and the processor may be further configured to evaluate the usage class of the user by comparing a moving path of the second moving object obtained based on the location of the second moving object with an optimal path considering the wind speed and the wind direction, when the load is the second moving object.

In an embodiment, the processor may be further configured to evaluate the usage class of the user based on data storing usage classes of a plurality of users.

In an embodiment, the data obtaining unit may be further configured to obtain the operation data from an internal memory of the battery pack.

An operating method of a battery operation management system according to an embodiment disclosed herein includes obtaining, from a battery pack, operation data of a load, related to a type of the load and state information of the battery pack, evaluating a usage class of a user operating the load based on the operation data and the state information of the battery pack, and selecting a battery pack to be provided to the user based on the usage class of the user in response to a battery pack providing request of the user.

In an embodiment, the operation of selecting the battery pack to be provided to the user based on the usage class of the user in response to the battery pack providing request of the user may include selecting a battery pack having a low degradation degree as the battery pack to be provided to the user for a high usage class of the user.

In an embodiment, the operation of evaluating the usage class of the user operating the load based on the operation data and the state information of the battery pack may include calculating a fuel efficiency of the load based on the operation data of the load and the state information of the battery pack and evaluating the usage class of the user based on the calculated fuel efficiency.

In an embodiment, the type of the load may include a first moving object traveling on the ground and a second moving object that flies.

In an embodiment, the operation data of the first moving object may include traveling distance, a location, and an altitude of the first moving object, and the operation data of the second moving object may include traveling distance, a location, a wind speed, and a wind direction of the second moving object.

In an embodiment, the operation of evaluating the usage class of the user operating the load based on the operation data and the state information of the battery pack may include evaluating the usage class of the user by comparing a moving path of the first moving object obtained based on the location of the first moving object with an optimal path considering the altitude, when the load is the first moving object, and evaluating the usage class of the user by comparing a moving path of the second moving object obtained based on the location of the second moving object with an optimal path considering the wind speed and the wind direction, when the load is the second moving object.

### [ADVANTAGEOUS EFFECTS]

With a battery operation management system and an operating method thereof according to an embodiment disclosed herein, it is possible to provide a battery exchange service considering a battery usage class of a user.

Moreover, the battery operation management system and the operating method thereof according to an embodiment disclosed herein may stably manage the lifespan of a battery.

### [DESCRIPTION OF DRAWINGS]

FIG. 1 is a diagram conceptually showing a battery operation management system according to an embodiment disclosed herein.
FIG. 2 is a block diagram of a battery operation management system according to an embodiment disclosed herein.
FIG. 3 is a view for describing an operation of a battery operation management system, according to an embodiment disclosed herein.
FIG. 4 is a flowchart showing an operating method of a battery operation management, system according to an embodiment disclosed herein.
FIG. 5 is a diagram showing a computing system according to another embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

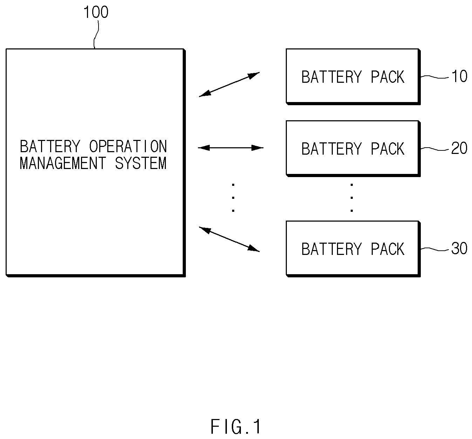

FIG. 1 is a diagram conceptually showing a battery operation management system according to an embodiment disclosed herein.

Referring to FIG. 1, a battery operation management system 100 according to an embodiment disclosed herein may provide a battery exchange service. For example, the battery operation management system 100 may provide a user with a battery exchange service by collecting battery packs 10, 20, and 30 returned from the user and providing other previously charged battery packs to the user.

Herein, the battery packs 10, 20, and 30 may be mounted on various types of loads and may be used to supply power. For example, the battery pack 10 may be mounted on a moving object traveling on or under the ground to supply power, and the battery packs 20 and 30 may be mounted on a flying object to supply power, without being limited thereto. Meanwhile, the battery operation management system 100 may recharge the collected battery packs 10, 20, and 30 through a charging device (not shown) to use them for a battery exchange service.

Depending on an embodiment, the battery operation management system 100 may be implemented in the form of a server, and may be arranged in a service station where the battery exchange service is provided or in a space that is separate from the service station. The battery operation management system 100 may be implemented in the form of an application.

The battery operation management system 100 may manage user information of an individual user. For example, the battery operation management system 100 may manage a usage class of a user using the battery packs 10, 20, and 30 each mounted in a load. The battery operation management system 100 may manage a state of charge (SOC) and/or a state of health (SOH) of battery packs used for providing a service. The battery operation management system 100 may provide previously stored another battery pack to the user based on a usage class of the user.

The battery operation management system 100 may obtain various data from the battery packs 10, 20, and 30. Depending on an embodiment, the obtained various data may be used for the battery operation management system 100 to evaluate the usage class of the user. The battery operation management system 100 may obtain operation data of a load on which each of the battery packs 10, 20, and 30 is mounted and state information of each of the battery packs 10, 20, and 30, from each of the battery packs 10, 20, and 30.

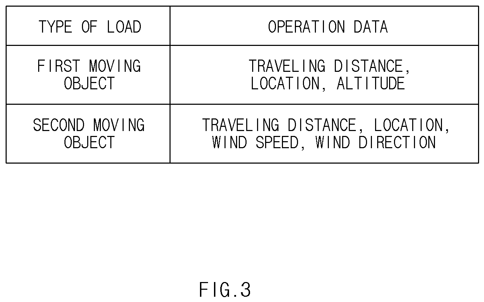

Depending on an embodiment, the operation data of the load may include different data according to a type of the load. The operation data of the load will be described in more detail with reference to FIG. 3 below. For example, the operation data of the load and the state information of each of the plurality of battery packs 10, 20, and 30 may be stored in an internal memory. Meanwhile, the battery operation management system 100 may obtain the operation data of the load and the state information from the battery packs 10, 20, and 30 through various wired or wireless networks.

The battery operation management system 100 may evaluate a usage class of the user operating the load having mounted thereon each of the battery packs 10, 20, and 30, based on the operation data of the load and the state information of each of the battery packs 10, 20, and 30. For example, the battery operation management system 100 may calculate a usage class of the user, based on fuel economy (or electricity consumtion) of the load calculated based on the operation data of the load and the state information of each of the battery packs 10, 20, and 30.

The battery operation management system 100 may select a battery pack to be provided to the user based on the usage class of the user in response to a battery pack providing request from the user. For example, the battery operation management system 100 may select a battery pack having a lower degradation degree as a battery pack to be provided to the user, for a higher usage class of the user. That is, a user having the higher usage class may receive a battery pack having a lower degradation degree than a user having the lower usage class. The user having the higher usage class is likely to operate a load stably, which may be eventually connected to the lifespan of the battery pack. Thus, the battery operation management system 100 may stably manage the lifespan of battery packs used to provide a service.

Moreover, the battery operation management system 100 may induce an effort to improve the usage class of the user by providing a battery exchange service to the user based on the usage class of the user, and improve service utility by improving a service usage rate of users having high usage classes.

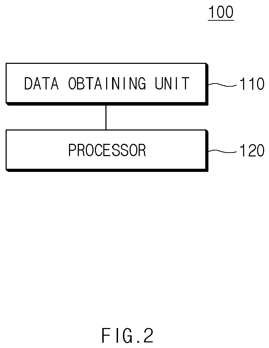

Hereinbelow, a configuration and an operation of the battery operation management system 100 will be described in more detail with reference to FIGS. 2 and 3.

FIG. 2 is a block diagram of a battery operation management system according to an embodiment disclosed herein. FIG. 3 is a view for describing an operation of a battery operation management system, according to an embodiment disclosed herein.

Referring to FIG. 2, the battery operation management system 100 may include a data obtaining unit 110 and a processor 120.

The data obtaining unit 110 may obtain operation data of a load, related to a type of the load and state information of each of the battery packs 10, 20, and 30 from each of the battery packs 10, 20, and 30. For example, the load may include a first moving object traveling on the ground or under the ground and a second moving object that flies.

Referring to FIG. 3, depending on an embodiment, when the battery pack 10 is used, mounted on the first moving object, the data obtaining unit 110 may obtain traveling distance, location, and altitude information as operation data of a load from the battery pack 10. Depending on an embodiment, when the battery packs 20 and 30 are used, mounted on the second moving object, the data obtaining unit 110 may obtain traveling distance, location, and wind speed and wind direction information as operation data of loads from the battery packs 20 and 30.

Meanwhile, the state information of the battery packs 10, 20, and 30 may include, but not limited to, a voltage V, a current I, a temperature T, a state of charge (SOC), and a state of health (SOH) of each of the battery packs 10, 20, and 30. The data obtaining unit 110 may transmit the obtained operation data of the load and state information of the battery pack to the processor 120.

Referring back to FIG. 2, the processor 120 may evaluate the usage class of the user operating the load based on the operation data of the load and the state information of the battery pack. For example, the processor 120 may calculate the fuel efficiency (or electricity consumption) of the load during the use of the battery packs 10, 20, and 30 by the user based on the operation data of the load and the state information of the battery pack. Depending on an embodiment, the processor 120 may calculate the fuel efficiency of the load based on the amount of reduction of the SOC and the traveling distance during the use of the battery packs 10, 20, and 30 by the user.

The processor 120 may evaluate the user's usage class based on the calculated fuel efficiency. For example, the processor 120 may evaluate the user's usage class as being higher for a higher fuel efficiency calculated.

When the load of the processor 120 is the first moving object, a traveling path of the load may be obtained based on a location and an altitude included in the operation data of the load. The processor 120 may compare the obtained moving path of the load with a previously stored optimal path to evaluate the user's usage class. Depending on an embodiment, the previously stored optimal path may mean a path that is the shortest path and the minimum altitude change among various paths existing between a source location and a destination location. The processor 120 may evaluate the user's usage class as being high when the degree of agreement between the obtained moving path of the load and the previously stored optimal path is high. By collectively considering the user's usage class based on the user's usage class and the fuel efficiency based on the degree of agreement between the moving path of the load and the previously stored optimal path, the processor 120 may evaluate a final usage class.

When the load of the processor 120 is the second moving object, a traveling path of the load may be obtained based on a location included in the operation data of the load. The processor 120 may compare the obtained moving path with the optimal path considering the wind speed and wind direction to evaluate the user's usage class. Depending on an embodiment, the previously stored optimal path may mean a path with the highest wind speed where the moving direction of the load corresponds to the wind direction, among various paths existing between a source location and a destination location. The processor 120 may evaluate the user's usage class as being high when the degree of agreement between the obtained moving path of the load and the previously stored optimal path is high. By collectively considering the user's usage class based on the user's usage class and the fuel efficiency based on the degree of agreement between the moving path of the load and the previously stored optimal path, the processor 120 may evaluate a final usage class.

Depending on an embodiment, the processor 120 may evaluate the user's usage class based on data storing usage classes of a plurality of users. That is, the usage class of the user may be a relative class.

The processor 120 may select a battery pack to be provided to the user based on the usage class of the user. For example, the processor 120 may select a battery pack having a lower degradation degree as a battery pack to be provided to the user, for a higher usage class of the user. The user having the higher usage class is likely to operate a load stably, which may be eventually connected to the lifespan of the battery pack. Thus, the battery operation management system 100 may stably manage the lifespan of battery packs used to provide a service.

Moreover, the battery operation management system 100 may induce an effort to improve the usage class of the user by providing a battery exchange service to the user based on the usage class of the user, and improve service utility by improving a service usage rate of users having high usage classes.

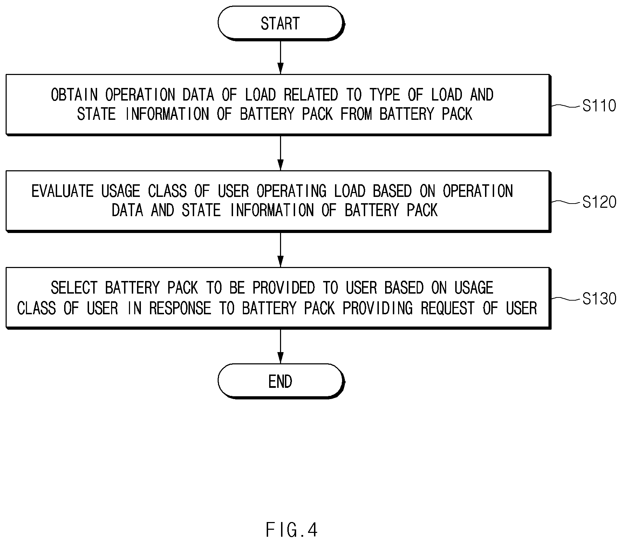

FIG. 4 is a flowchart showing an operating method of a battery operation management system, according to an embodiment disclosed herein.

Referring to FIG. 4, an operating method of a battery operation management system according to an embodiment disclosed herein may include operation S 110 of obtaining operation data of a load, related to a type of the load and state information of a battery pack from the battery pack, operation S120 of evaluating a usage class of a user operating the load based on the operation data and the state information of the battery pack, and operation S 130 of selecting a battery pack to be provided to the user based on the usage class of the user in response to a battery pack providing request of the user.

Hereinbelow, operations S110 through S130 will be described in detail with reference to FIGS. 1 and 2.

In operation S110, the data obtaining unit 110 may obtain operation data of a load, related to a type of the load and state information of each of the battery packs 10, 20, and 30 from each of the battery packs 10, 20, and 30. For example, the load may include a first moving object traveling and a second moving object flying on the ground or under the ground.

Meanwhile, the state information of the battery packs 10, 20, and 30 may include, but not limited to, a voltage V, a current I, a temperature T, an SOC, and an SOH of each of the battery packs 10, 20, and 30.

In operation S120, the processor 120 may evaluate the usage class of the user operating the load based on the operation data of the load and the state information of the battery pack. Depending on an embodiment, the processor 120 may calculate the fuel efficiency of the load based on the amount of reduction of the SOC and the traveling distance during the use of the battery packs 10, 20, and 30 by the user. The processor 120 may evaluate the user's usage class based on the calculated fuel efficiency. For example, the processor 120 may evaluate the user's usage class as being higher for a higher fuel efficiency calculated.

For example, when the load of the processor 120 is the first moving object, a traveling path of the load may be obtained based on a location and an altitude included in the operation data of the load. The processor 120 may compare the obtained moving path of the load with a previously stored optimal path to evaluate the user's usage class. The processor 120 may evaluate the user's usage class as being high when the degree of agreement between the obtained moving path of the load and the previously stored optimal path is high.

Moreover, for example, when the load of the processor 120 is the second moving object, a traveling path of the load may be obtained based on a location included in the operation data of the load. The processor 120 may compare the obtained moving path with the optimal path considering the wind speed and wind direction to evaluate the user's usage class. The processor 120 may evaluate the user's usage class as being high when the degree of agreement between the obtained moving path of the load and the previously stored optimal path is high.

In operation S130, the processor 120 may select a battery pack to be provided to the user based on the usage class of the user. For example, the processor 120 may select a battery pack having a lower degradation degree as a battery pack to be provided to the user, for a higher usage class of the user.

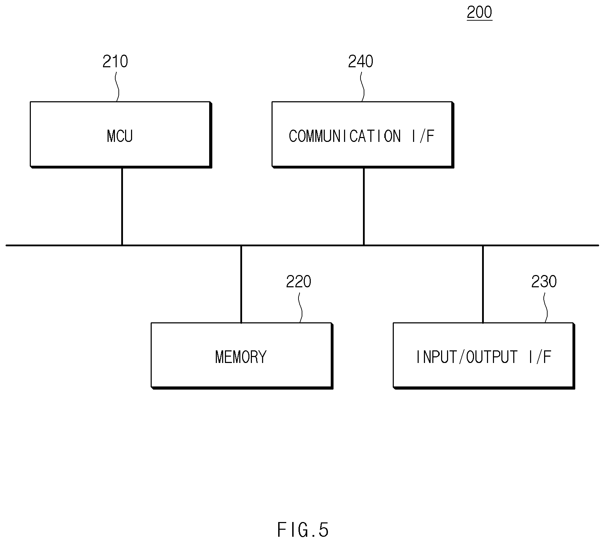

FIG. 5 is a diagram showing a computing system according to another embodiment disclosed herein.

Referring to FIG. 5, a computing system 200 according to an embodiment disclosed herein may include an MCU 210, a memory 220, an input/output interface (I/F) 230, and a communication I/F 240.

The MCU 210 may be a processor that executes various programs (e.g., an SOH calculation program, a cell balancing target determination program, etc.) stored in the memory 220, processes various data including an SOC, an SOH, etc., of a plurality of battery cells through these programs, executes functions of the battery operation management system 100 described above with reference to FIG. 1, or executes the operating system of the battery operation management system described with reference to FIG. 4.

The memory 220 may store various programs regarding SOH calculation of the battery cell, cell balancing target determination, etc. Moreover, the memory 220 may store various data such as SOC data, SOH data, etc., of each battery cell.

The memory 220 may be provided in plural, depending on a need. The memory 220 may be volatile memory or non-volatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., to the MCU 210.

The communication I/F 230, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 230.

As such, an operating method of a battery operation management system according to an embodiment disclosed herein may be recorded in the memory 220 and executed by the MCU 210.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

### [DESCRIPTION OF SYMBOLS]

10, 20, 30 Battery Packs
100: Battery Operation Management System
110: Data Obtaining Unit
120: Processor
200: Computing System
210: MCU
220: Memory
230: Input/Output I/F
240: Communication I/F

## Claims

1. A battery operation management system comprising:
a data obtaining unit configured to obtain, from a battery pack, operation data of a load, related to a type of the load and state information of the battery pack; and
a processor configured to evaluate a usage class of a user operating the load based on the operation data of the load and the state information of the battery pack and select a battery pack to be provided to the user based on the usage class of the user in response to a battery pack providing request of the user.

2. The battery operation management system of claim 1, wherein the processor is further configured to select, as the battery pack to be provided to the user, a battery pack having a lower degradation degree for a higher usage class of the user.

3. The battery operation management system of claim 1, wherein the processor is further configured to calculate a fuel efficiency of the load based on the operation data of the load and the state information of the battery pack and evaluate the usage class of the user based on the calculated fuel efficiency.

4. The battery operation management system of claim 3, wherein the type of the load comprises a first moving object that travels on the ground and a second moving object that flies.

5. The battery operation management system of claim 4, wherein the operation data of the first moving object comprises traveling distance, a location, and an altitude of the first moving object, and
the operation data of the second moving object comprises traveling distance, a location, a wind speed, and a wind direction of the second moving object.

6. The battery operation management system of claim 5, wherein the processor is further configured to evaluate the usage class of the user by comparing a moving path of the first moving object obtained based on the location of the first moving object with an optimal path considering the altitude, when the load is the first moving object, and
the processor is further configured to evaluate the usage class of the user by comparing a moving path of the second moving object obtained based on the location of the second moving object with an optimal path considering the wind speed and the wind direction, when the load is the second moving object.

7. The battery operation management system of claim 1, wherein the processor is further configured to evaluate the usage class of the user based on data storing usage classes of a plurality of users.

8. The battery operation management system of claim 1, wherein the data obtaining unit is further configured to obtain the operation data from an internal memory of the battery pack.

9. An operating method of a battery operation management system, the operating method comprising operations of:
obtaining, from a battery pack, operation data of a load, related to a type of the load and state information of the battery pack;
evaluating a usage class of a user operating the load based on the operation data of the load and the state information of the battery pack; and
selecting a battery pack to be provided to the user based on the usage class of the user in response to a battery pack providing request of the user.

10. The operating method of claim 9, wherein the operation of selecting the battery pack to be provided to the user based on the usage class of the user in response to the battery pack providing request of the user comprises selecting a battery pack having a low degradation degree as the battery pack to be provided to the user for a high usage class of the user.

11. The operating method of claim 9, wherein the operation of evaluating the usage class of the user operating the load based on the operation data and the state information of the battery pack comprises calculating a fuel efficiency of the load based on the operation data of the load and the state information of the battery pack and evaluating the usage class of the user based on the calculated fuel efficiency.

12. The operating method of claim 11, wherein the type of the load comprises a first moving object that travels on the ground and a second moving object that flies.

13. The operating method of claim 12, wherein the operation data of the first moving object comprises traveling distance, a location, and an altitude of the first moving object, and
the operation data of the second moving object comprises traveling distance, a location, a wind speed, and a wind direction of the second moving object.

14. The operating method of claim 13, wherein the operation of evaluating the usage class of the user operating the load based on the operation data and the state information of the battery pack comprises:
evaluating the usage class of the user by comparing a moving path of the first moving object obtained based on the location of the first moving object with an optimal path considering the altitude, when the load is the first moving object, and
evaluating the usage class of the user by comparing a moving path of the second moving object obtained based on the location of the second moving object with an optimal path considering the wind speed and the wind direction, when the load is the second moving object.
